# EUROPEAN PATENT APPLICATION

(11) **EP 2 371 929 A1**
(43) Date of publication of application: **05.10.2011**
(21) Application number: 11159693.8
(22) Date of filing: 25.03.2011
(51) Int. Cl.: C09K 11/77, C09K 11/02

(54) **Phosphor, method of coating the same, and method of manufacturing light emitting apparatus**

(30) Priority: 25.03.2010 KR 20100026940
(71) Applicant: LG Innotek Co., Ltd., Seoul 100-714 (KR)
(72) Inventor: An, Joong In, Seoul 100-714 (KR)
(74) Representative: Zardi, Marco

(57) **Abstract**

Disclosed are a phosphor, a method of coating the same, and a method of manufacturing a light emitting apparatus. The method of coating a phosphor includes preparing a phosphor core, primarily stirring the phosphor core in a first solution including first polymer and first solvent, aging the first solution, secondarily stirring the phosphor core in a second solution obtained by adding second polymer and second solvent to the first solution, and acquiring a phosphor coated with the polymer by drying the second solution.

## Description

### Background

### 1. Field

This relates to a phosphor, and in particular, to a method of coating a phosphor.

### 2. Background

A light emitting diode (LED) is a semiconductor light emitting device that converts current into light. An LED can generate light having a high level of brightness, and may be used as a light source in numerous different types of devices.

### SUMMARY OF INVENTION

Embodiments provide a phosphor, a method of coating the same, and a method of manufacturing a light emitting apparatus. The method of coating a phosphor includes preparing a phosphor core, primarily stirring the phosphor core in a first solution including first polymer and first solvent, aging the first solution, secondarily stirring the phosphor core in a second solution obtained by adding second polymer and second solvent to the first solution, and acquiring a phosphor coated with the polymer by drying the second solution.

### BRIEF DESCRIPTION OF THE DRAWINGS

The embodiments will be described in detail with reference to the following drawings in which like reference numerals refer to like elements wherein:

FIG. 1 is a flowchart of a method of coating a phosphor, in accordance with an embodiment as broadly described herein;

FIG. 2 is a photograph of an exemplary phosphor core which may be used in the method shown in FIG. 1;

FIG. 3 is a photograph of an exemplary phosphor coated using the method shown in FIG. 1;

FIG. 4 is a graph of light emission characteristics of a phosphor coated using the method shown in FIG. 1;

FIG. 5 is a flowchart of a method of manufacturing a light emitting apparatus, in accordance with an embodiment as broadly described herein; and

FIG. 6 is a sectional view of an exemplary light emitting apparatus using the method shown in FIG. 5.

### DETAILED DESCRIPTION

In the following description, when a layer (or film), a region, a pattern, or a structure is referred to as being "on" or "under" another substrate, another layer (or film), another region, another pad, or another pattern, it may be "directly" or "indirectly" over the other substrate, layer (or film), region, pad, or pattern, or one or more intervening layers may also be present. Such a position may be described with reference to the drawings. A thickness and size of each layer shown in the drawings may be exaggerated, omitted or schematically drawn for purposes of convenience or clarity. In addition, the size of elements may not ultimately reflect an actual size.

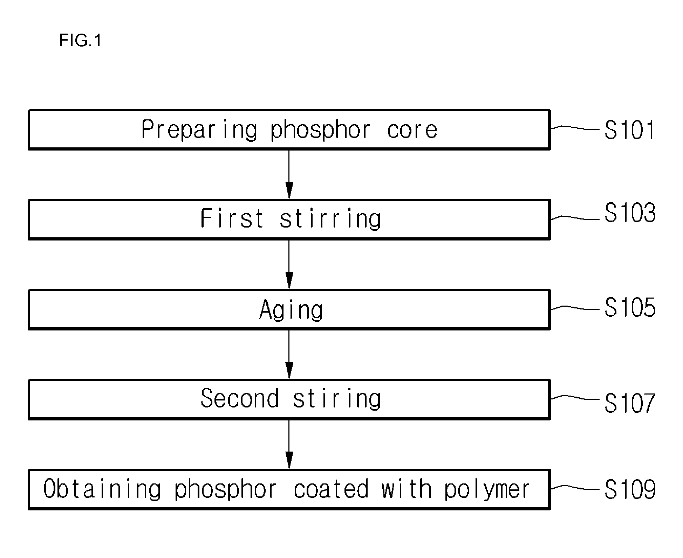

In a method of coating a phosphor as shown in FIG. 1, a phosphor core may be provided (step S101) and may undergo a first stirring, or mixing, in a first solution, or mixture (step S103). The first solution, or mixture, may include, for example, a first polymer and a first solvent.

The phosphor core may be, for example, a sulfide phosphor. Such a sulfide phosphor may be, for example, CaS:Eu2+, SrS:Eu2+ or other sulfide as appropriate. In alternative embodiments, such a sulfide phosphor may be selected from the group consisting of CaS:Eu2+ and SrS:Eu2+. The first polymer may include, for example, PMMA (polymethyl methacrylate), PVA (polyvinyl alcohol), PVB (polyvinyl butyral), or other polymer as appropriate. In alternative embodiments, the first polymer may include at least one selected from the group consisting of PMMA, PVA and PVB.

The first solvent may include a polar solvent, such as, for example, alcohol, or other solvent as appropriate. The first stirring, or mixing process may be performed at a predetermined first temperature for a predetermined first time, such as, for example, a predetermined first temperature of 60°C to 70°C for a predetermined first time of two hours to four hours. In certain embodiments, the first stirring, or mixing, process may be performed at a predetermined first temperature of 65°C for a predetermined first time of three hours. Other combinations of temperature and time may also be appropriate.

Next, an aging process may be performed on the first solution that has been subjected to the first stirring process (step S105). The aging process may be performed at a predetermined aging temperature, such as, for example, a room temperature, such as, for example, between 15°C and 30°C, for a predetermined aging time, such as, for example, one hour to two hours. The temperature range may be 20°C and 25°C. In particular, in the aging process, the first solvent that has been subjected to the first stirring process may remain at a predetermined aging temperature for a predetermined aging time to allow the chemical reaction related to the coating of the polymer core to be sufficiently performed and obtain desired coating properties.

Subsequently, a second polymer and a second solvent may be added to the first solution that has been subjected to the first stirring, or mixing, process and the aging process, and a second stirring, or mixing, process may be performed on the resulting second solution (step S107).

The second polymer may include, for example, PMMA (poly methy methacrylate), PVA (polyvinyl alcohol), PVB (polyvinyl butyral), or other polymer as appropriate. The second solvent may include a polar solvent, such as, for example, alcohol, or other solvent as appropriate. The second stirring, or mixing, process may be performed at a second predetermined temperature of, for example, 60°C to 70°C, for a second predetermined time of, for example, nine hours to twelve hours. In certain embodiments, the second stirring, or mixing, process may be performed at a predetermined second temperature of 65°C for a predetermined second time of 10 hours. Other combinations of temperature and time may also be appropriate.

In certain embodiments, the second polymer may include a material that is the same as that of the first polymer, so that the same polymer may be uniformly coated on the phosphor. However, in alternative embodiments, the second polymer may include material that is different from that of the first polymer. Similarly, the second solvent may include material that is the same as that of the first solvent, or alternatively, the second solvent may include material that is different from that of the first solvent.

The aging process may be performed between the first and second stirring, or mixing, processes, so that the polymer may be smoothly coated on the phosphor.

Then, the second solution, which has been subjected to the second stirring process, may be dried, so that a phosphor coated with a polymer is produced (step S109).

The drying process may be performed at a predetermined drying temperature of, for example, 75°C to 85°C. In certain embodiments, the drying process may be performed at a predetermined drying temperature of 80 for a predetermined drying time sufficient to provide for drying of the solution. In certain embodiments, when the drying is performed, a sonication process may also be performed, together with maintaining the temperature at the predetermined drying temperature.

During the first/second stirring, or mixing, processes, the phosphor core may be stirred, or spun, or mixed to form the first/second solution, or mixture using various different methods. For example, the first/second solution, or mixture, may be centrifuged at an appropriate speed at the predetermined first/second temperature for the predetermined first/second time. Other manners of stirring or mixing the prescribed components may also be appropriate.

In such a manner, a phosphor coated with a polymer in accordance with an embodiment as broadly described herein may be obtained. In certain embodiments, a phosphor coated in this manner may include a sulfide phosphor core and polymer coated on the surface of the sulfide phosphor core.

In certain embodiments, the sulfide phosphor may be CaS:Eu2+, SrS:Eu2+, or other sulfide phosphor as appropriate, and the polymer may include PMMA, PVA, PVB, or other polymer as appropriate. In alternative embodiments, the phosphor core may include at least one selected from the group consisting of CaS:Eu2+ and SrS:Eu2+.

In a sulfide phosphor coated with a polymer as described above, the polymer coating may allow a reaction between the sulfide phosphor core and surrounding materials to be somewhat controlled compared to an uncoated sulfide phosphor, which may be more likely to react with surrounding materials.

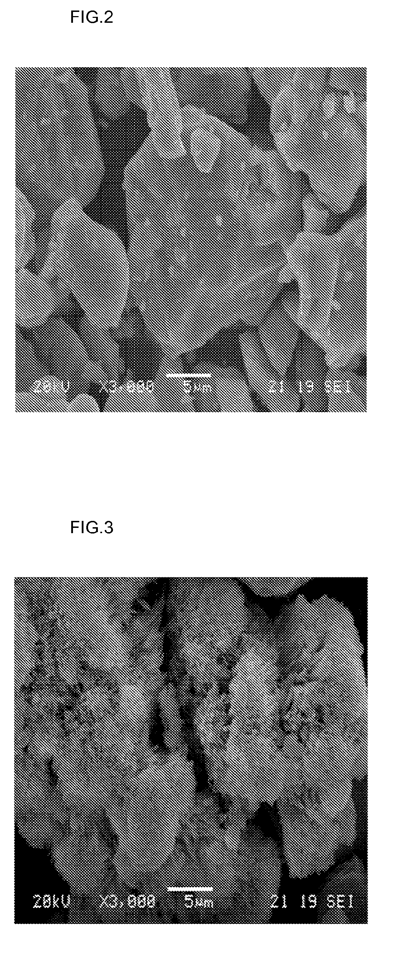

For example, a sulfide phosphor may be distributed in a molding member, or filler, including a resin provided on a light emitting device. The light emitting device may be provided on a body, and may be electrically connected to one or more electrode layers. In this type of arrangement, an uncoated sulfide phosphor may react with the electrode layers. Additionally, an uncoated sulfide phosphor may react with a metallic material included in the apparatus for its reflective properties. For example, if a metallic material, such as, for example, silver (Ag), were included in the light emitting device, the uncoated sulfide phosphor could react with the silver. In contrast, a phosphor coated with a polymer as embodied and broadly described herein may prevent the phosphor core from reacting with surrounding materials, such as, for example, the silver described in the example above. FIG. 2 is a photograph of an exemplary uncoated phosphor core, and FIG. 3 is a photograph an exemplary coated phosphor in accordance with the method as embodied and broadly described herein.

Various characteristics of an LED, such as, for example, brightness of the LED, may be affected by various different factors, such as, for example, the structure of an active layer, a light extracting structure capable of effectively extracting light to the outside, semiconductor material used in the LED, the material of a phosphor, a chip size, a type of a molding member or filler surrounding the LED, and numerous other factors. As shown in FIGS. 2 and 3, polymer may be attached to substantially the entire surface of the phosphor core using the method of coating the phosphor according to embodiments as broadly described herein. Such a polymer may be uniformly attached to the outer surface of the phosphor core, so that a specific gravity of the phosphor may be controlled. This may allow the phosphor to be uniformly distributed into the molding part or filler including resin as described above, so that one or more characteristics of light emitted through the molding part or filler containing such a phosphor may be stably controlled.

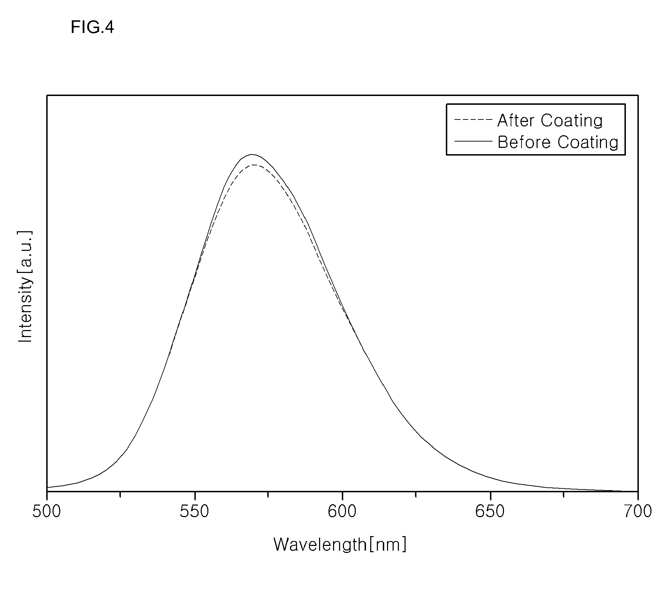

FIG. 4 is a graph of light emission characteristics of a phosphor coated with a polymer using the method described above. As shown in FIG. 4, light emission characteristics of a phosphor coated with a polymer may be similar to, or substantially the same as, those of an uncoated phosphor. As shown in FIG. 4, the coated phosphor may emit light in the wavelength band of about 500nm to about 675 nm, and may emit light having a main wavelength band in the range of about 550nm to about 660nm. Thus, the coating of the phosphor core has little to no impact on intensity, while improving other characteristics, such as, for example, reflection.

A coated phosphor as embodied and broadly described herein may be applicable to a light emitting device and/or a light emitting device package. Such a light emitting device package may include at least one light emitting device, for example, a light emitting diode. Such a light emitting device package may also include at least one phosphor layer.

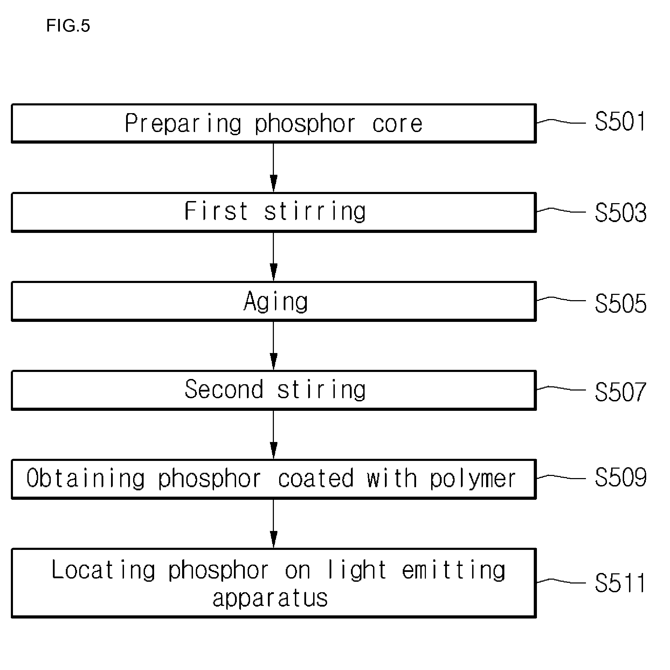

FIG. 5 is a flowchart of a method of manufacturing a light emitting apparatus in accordance with an embodiment as broadly described herein.

As shown in FIG. 5, a phosphor core is provided (step S501), and undergoes a first stirring, or mixing, in a first solution, or mixture, including a first polymer and a first solvent (step S503).

The phosphor core may be, for example, a sulfide phosphor. The sulfide phosphor may be CaS:Eu2+, SrS:Eu2+, or other sulfide phosphor as appropriate. In certain embodiments, the phosphor core includes at least one selected from the group consisting of CaS:Eu2+ and SrS:Eu2+. In addition, the first polymer may include PMMA (polymethyl methacrylate), PVA (polyvinyl alcohol), PVB (polyvinyl butyral), or other polymer as appropriate. The first solvent may include a polar solvent, such as, for example, alcohol, or other solvent as appropriate. The first stirring, or mixing, process may be performed at a predetermined first temperature of, for example, 60°C to 70°C for a predetermined first time of, for example, two hours to four hours. In certain embodiments, the first stirring, or mixing, process may be performed at a predetermined first temperature of 65°C for a predetermined first time of three hours. Other combinations of temperature and time may also be appropriate.

Next, an aging process may be performed on the first solution, or mixture, that has been subjected to the first stirring, or mixing, process (step S505). The aging process may be performed at a predetermined aging temperature, such as, for example, a normal temperature or a room temperature, such as, for example, 15°C to 30°C, for a predetermined aging time of, for example, one hour to two hours. Other combinations of temperature and time may also be appropriate.

Subsequently, a second polymer and a second solvent may be added to the first solution, or mixture, that has been subjected to the first stirring, or mixing, process and the aging process, and a second stirring, or mixing, process may be performed with respect to the resulting second solution, or mixture (step S507).

The second polymer may include, for example, PMMA (poly methy methacrylate), PVA (polyvinyl alcohol), PVB (polyvinyl butyral) or other polymer as appropriate. The second solvent may include, for example, a polar solvent, such as, for example, alcohol, or other solvent as appropriate. The second stirring, or mixing, process may be performed at a predetermined second temperature of, for example, 60°C to 70°C for a predetermined second time of, for example, nine hours to twelve hours. In certain embodiments, the second stirring, or mixing, process may be performed at a second predetermined temperature of 65°C for a second predetermined time of 10 hours.

The second polymer may include material that is the same as that of the first polymer, so that the same polymer may be uniformly coated on the phosphor. In alternative embodiments, the second polymer may include material that is different from that of the first polymer. Similarly, the second solvent may include material that is the same as that of the first solvent, or the second solvent may include material that is different from that of the first solvent.

A phosphor coated with a polymer may then be obtained by drying the second solution that has been subjected to the second stirring, or mixing, process (step S509).

The drying process may be performed at a predetermined drying temperature of, for example, 75°C to 85°C. In certain embodiments, the drying process may be performed at a predetermined drying temperature of, for example, 80°C for a predetermined drying time, sufficient to provide for drying of the second solution, or mixture. In addition, a sonication process may be performed together with the drying process.

As previously described, the sulfide phosphor may be CaS:Eu2+, SrS:Eu2+, or other sulfide phosphor as appropriate, and the polymer may include PMMA, PVA, PVB, or other polymer as appropriate. Other combinations may also be appropriate.

The coated phosphor may then be provided on a light emitting device (step S511).

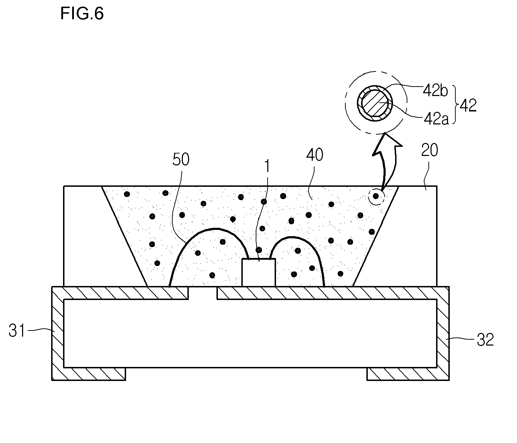

Hereinafter, an exemplary light emitting apparatus including such a light emitting device including such a coated phosphor will be described with reference to FIG. 6.

The light emitting apparatus shown in FIG. 6 may include a body 20, first and second electrode layers 31 and 32, a light emitting device 1 provided in the body 20 and electrically connected to the first and second electrode layers 31 and 32, and a molding member, or filler 40, surrounding the light emitting device 1.

The body 20 may include silicon, synthetic resin, metallic material, or other material as appropriate. The body 20 may include an inclined surface formed around the light emitting device 1.

The first and second electrode layers 31 and 32 may be electrically insulated from each other to supply power to the light emitting device 1. In addition, the first and second electrode layers 31 and 32 may reflect the light emitted from the light emitting device 1 to improve efficiency and dissipate heat generated by the light emitting device 1.

The light emitting device 1 may be installed on the body 20, on the first and second electrode layers 31 and 32, or other location as appropriate.

In certain embodiments, the light emitting device 1 may be electrically connected to the first and second electrode layers 31 and 32 by a wire 50. In alternative embodiments, the light emitting device 1 may be electrically connected to the first and second electrode layers 31 and 32 using, for example, a flip-chip scheme, a die-bonding scheme, or other arrangement as appropriate.

The molding member, or filler 40 may surround the light emitting device 1. In addition, the molding member, or filler 40 may include a phosphor 42 that may affect the wavelength of light emitted by the light emitting device 1 as it passes therethrough.

In this embodiment, the phosphor 42 provided in the molding member 40 may be coated with a polymer 42b, so that the reaction between a phosphor core 42a including a sulfide and surrounding materials may be controlled.

In this embodiment, the polymer 42b may be formed, substantially uniformly, at the circumference of the phosphor core 42a, so that a specific gravity of the phosphor 42 may be controlled, allowing the phosphor 42 to be uniformly distributed into the filler 40 including resin when the phosphor 42 is molded on the light emitting device 1. Accordingly, the phosphor 42 may be uniformly distributed throughout the filler 40, so that one or more characteristics of light emitted by the filler 40 containing such a phosphor 42 may be stably controlled.

The phosphor 42 including the polymer 42b may prevent the phosphor core 42a from reacting with the first and second electrode layers 31 and 32. In this embodiment, the polymer 42b is coated on the phosphor core 42a, so that a reaction between the phosphor core 42a including a sulfide and the surrounding materials may be controlled.

An exemplary light emitting apparatus may include a light emitting device that emits blue light, and a yellow phosphor, so as to supply white light from the emitted blue light. However, such a white light emitting apparatus may not always sufficiently represent natural colors of an object due to the lack of green and red spectrums. A UV light emitting device that emits visible light from blue to red and the phosphor 42 including a phosphor core 42a coated with a phosphor 42b as described above may produce white light approaching natural color by preventing the phosphor core 42a from reacting with surrounding materials. Accordingly, a light emitting apparatus in which red, green, and blue phosphors are provided on a UV light emitting device may be provided in which each phosphor 42 is prevented from reacting with surrounding materials and white light approximating white color may be supplied.

A phosphor, a method of coating such a phosphor, and a method of manufacturing a light emitting device including such a phosphor are provided.

A method of coating a phosphor as embodied and broadly described herein may include preparing a phosphor core, primarily stirring the phosphor core in a first solution including first polymer and first solvent, aging the first solution, secondarily stirring the phosphor core in a second solution obtained by adding second polymer and second solvent to the first solution, and acquiring a phosphor coated with a polymer by drying the second solution.

A method of manufacturing a light emitting apparatus as embodied and broadly described herein may include preparing a phosphor core, stirring the phosphor core in a first solution including first polymer and first solvent, aging the first solution, secondarily stirring the phosphor core in a second solution obtained by adding second polymer and second solvent to the first solution, acquiring a phosphor coated with the polymer by drying the second solution, and placing the phosphor coated with a polymer on a light emitting device.

In certain embodiments, a phosphor may include a phosphor core including sulfide, and polymer coated on a surface of the phosphor core.

Any reference in this specification to "one embodiment," "an embodiment," "example embodiment," etc., means that a particular feature, structure, or characteristic described in connection with the embodiment is included in at least one embodiment as broadly described herein. The appearances of such phrases in various places in the specification are not necessarily all referring to the same embodiment. Further, when a particular feature, structure, or characteristic is described in connection with any embodiment, it is submitted that it is within the purview of one skilled in the art to affect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A method of coating a phosphor, the method comprising:
mixing a phosphor core in a first mixture including a first polymer and a first solvent;
aging the first mixture;
mixing a second polymer and a second solvent into the first mixture to produce a second mixture; and
drying the second mixture to produce a coated phosphor.

2. The method of claim 1, wherein the phosphor core includes a sulfide.

3. The method of claim 2, wherein the phosphor core includes at least one of CaS:Eu2+ or SrS:Eu2+.

4. The method of claim 1, wherein mixing the phosphor core in the first mixture at the first predetermined temperature for the first predetermined time comprises stirring the phosphor core in the first mixture at a temperature of between about 60°C and about 70°C for between about two to four hours.

5. The method of claim 1, wherein stirring the phosphor core in the second mixture at a second predetermined temperature for a second predetermined time comprises stirring the phosphor core at a temperature of between about 60°C and about 70°C for between about nine to twelve hours.

6. The method of claim 1, wherein the first polymer includes at least one of PMMA (poly methyl methacrylate), PVA (polyvinyl alcohol) or PVB (polyvinyl butyral).

7. The method of claim 1, wherein the second polymer includes at least one of PMMA (poly methyl methacrylate), PVA (polyvinyl alcohol) or PVB (polyvinyl butyral).

8. The method of claim 1, wherein the first polymer includes a material that is the same as a material of the second polymer.

9. The method of claim 1, wherein the first solvent is a polar solution.

10. The method of claim 1, wherein the second solvent is a polar solution.

11. The method of claim 1, wherein the first solvent includes a material that is the same as a material of the second solvent.

12. The method of claim 1, wherein drying the second mixture at a predetermined drying temperature for a predetermined drying time comprises drying the second mixture at a temperature of between about 75°C to about 85°C, and performing a sonication process together with drying the second mixture.

13. The method of claim 1, wherein aging the first mixture at a predetermined aging temperature for a predetermined aging time comprises aging the first mixture at a temperature of between about 15°C and 30°C for a time of between one hour to two hours.

14. A method of manufacturing a light emitting apparatus, the method comprising:
acquiring a phosphor coated with a polymer to a light emitting device by a method according to one of claims 1 to 13.

15. A phosphor comprising:
a phosphor core including sulfide; and
polymer coated by a method according to one of claims 1 to 13 on a surface of the phosphor core.
